(19) Europäisches Patentamt
European Patent Office
Office européen des brevets

(11) **EP 4 764 524 A1**

(12) **EUROPEAN PATENT APPLICATION**
published in accordance with Art. 153(4) EPC

(43) Date of publication:
**24.06.2026 Bulletin 2026/26**

(21) Application number: **24894745.9**

(22) Date of filing: **13.11.2024**

(51) International Patent Classification (IPC):
**G01R 31/367** (2019.01)  **G01R 31/396** (2019.01)
**G01R 31/392** (2019.01)  **G01R 31/382** (2019.01)
**G01R 31/36** (2020.01)

(52) Cooperative Patent Classification (CPC):
**G01R 31/36; G01R 31/367; G01R 31/382;**
**G01R 31/392; G01R 31/396;** Y02E 60/10

(86) International application number:
**PCT/KR2024/096480**

(87) International publication number:
**WO 2025/110855 (30.05.2025 Gazette 2025/22)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **20.11.2023 KR 20230160241**

(71) Applicant: **LG Energy Solution, Ltd.**
**Seoul 07335 (KR)**

(72) Inventors:
• **LEE, Jeong Min**
  **Daejeon 34122 (KR)**
• **KIM, Young Soon**
  **Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **BATTERY ANALYSIS DEVICE, BATTERY ANALYSIS METHOD AND RECORDING MEDIUM**

(57)    According to some embodiments, a battery analysis device includes a memory, and a processor operatively connected to the memory, wherein the processor is configured to specify a plurality of battery analysis factors required to analyze characteristics of a battery, identify a plurality of reference analysis models that are established in advance in relation to some of the plurality of battery analysis factors to analyze the characteristics of the battery, and derive a target analysis model that analyzes the characteristics of the battery by reflecting the plurality of battery analysis factors based on the plurality of reference analysis models.

FIG.2

EP 4 764 524 A1

## Description

### Technical Field

CROSS-REFERENCE TO RELATED APPLICATION

This application claims priority to and the benefit of Korean Patent Application No. 10-2023-0160241 filed in the Korean Intellectual Property Office on November 20, 2023, the entire contents of which are incorporated herein by reference.

TECHNICAL FIELD

Embodiments disclosed herein relate to a battery analysis device, a battery analysis method, and a recording medium.

### Background Art

Recently, research and development on secondary batteries has been actively conducted. Here, the secondary battery is a battery capable of charging and discharging and may be construed as including all recent lithium ion batteries such as conventional Ni/Cd batteries and Ni/MH batteries. Among secondary batteries, lithium ion batteries may have a higher energy density than conventional Ni/Cd batteries, Ni/MH batteries, etc. and may be manufactured in a compact and lightweight manner, and thus may have high usability in terms of power sources for mobile devices. Recently, the lithium-ion batteries are attracting attention as a next-generation energy storage medium as a range of use expands to a power source for an electric vehicle.

Experiments can be conducted to analyze the characteristics of batteries for specific conditions, and battery analysis models can be generated based on the result of the experiment. For example, a relationship formula that models battery lifetime degradation for a specific cell design method can be generated through experiments. A process of generating an analysis model can take a long time because it requires a lot of experiments and data acquisition.

### Disclosure

### Technical Problem

Embodiments disclosed herein are directed to providing a battery analysis device, a battery analysis method, and a recording medium, in which a process of generating an analysis model can be simplified using similar models.

Technical objects of embodiments disclosed herein are not limited to the above-described objects, and other objects that are not described will be able to be clearly understood by those skilled in the art from the following descriptions.

### Technical Solution

According to some embodiments, a battery analysis device includes a memory, and a processor operatively connected to the memory, wherein the processor is configured to specify a plurality of battery analysis factors required to analyze characteristics of a battery, identify a plurality of reference analysis models that are established in advance in relation to some of the plurality of battery analysis factors to analyze the characteristics of the battery, and derive a target analysis model that analyzes the characteristics of the battery by reflecting the plurality of battery analysis factors based on the plurality of reference analysis models.

According to some embodiments, the characteristics of the battery include battery lifetime degradation characteristics, and the plurality of battery analysis factors include a first factor related to a design of a battery cell and a second factor related to a state of charge (SOC) range of a charging and discharging cycle.

According to some embodiments, the battery lifetime degradation characteristics are represented by a change in internal resistance of the battery according to the number of times the charging and discharging cycle, and the plurality of reference analysis models include a plurality of relationship formulas between the number of times the charging and discharging cycle and a change in internal resistance of the battery.

According to some embodiments, the plurality of relationship formulas of the plurality of reference analysis models include a first relationship formula related to a first reference factor that differ from the first factor and the second factor, a second relationship formula related to the first factor and a second reference factor that differs from the second factor, and a third relationship formula related to the first reference factor and the second reference factor.

According to some embodiments, the first relationship formula, the second relationship formula, and the third relationship formula include a first exponential relationship formula, a second exponential relationship formula, and a third exponential relationship formula that are derived through numerical analysis fitting for experimental data for the number of times the charging and discharge cycle and the change in internal resistance of the battery.

According to some embodiments, the processor is configured to derive a target exponential relationship formula of the target analysis model based on a proportional relationship using a first exponential relationship formula, a second exponential relationship formula, and a third exponential relationship formula.

According to some embodiments, the processor is configured to derive a first impact value due to a change in the first factor based on a difference between the second exponential relationship formula and the third exponential relationship formula, derive a second impact value due to a change in the second factor based on a difference between the first exponential relationship formula and the third exponential relationship, and derive a target exponential relationship formula of the target analysis model by applying the first impact value and the second impact value to the third exponential relationship formula.

According to some embodiments, the first exponential relationship formula, the second exponential relationship formula, and the third exponential relationship formula are formed in the form of $y = A1 * exp(x/t1) + y0$, and the first impact value and the second impact value include a change amount of at least one of coefficients A1, t1, and y0.

According to some embodiments, a battery analysis method includes specifying a plurality of battery analysis factors required to analyze characteristics of a battery, identifying a plurality of reference analysis models that are established in advance in relation to some of the plurality of battery analysis factors to analyze the characteristics of the battery, and deriving a target analysis model that analyzes the characteristics of the battery by reflecting the plurality of battery analysis factors based on the plurality of reference analysis models.

According to some embodiments, the characteristics of the battery include battery lifetime degradation characteristics, and the plurality of battery analysis factors include a first factor related to a design of a battery cell and a second factor related to a state of charge (SOC) range of a charging and discharging cycle.

According to some embodiments, the battery lifetime degradation characteristics are represented by a change in internal resistance of the battery according to the number of times the charging and discharging cycle, and the plurality of reference analysis models include a plurality of relationship formulas between the number of times the charging and discharging cycle and a change in internal resistance of the battery.

According to some embodiments, the plurality of relationship formulas of the plurality of reference analysis models include a first relationship formula related to a first reference factor that differ from the first factor and the second factor, a second relationship formula related to the first factor and a second reference factor that differs from the second factor, and a third relationship formula related to the first reference factor and the second reference factor.

According to some embodiments, the first relationship formula, the second relationship formula, and the third relationship formula include a first exponential relationship formula, a second exponential relationship formula, and a third exponential relationship formula that are derived through numerical analysis fitting for experimental data for the number of times the charging and discharge cycle and the change in internal resistance of the battery.

According to some embodiments, the deriving of the target analysis model includes deriving a target exponential relationship formula of the target analysis model based on a proportional relationship using the first exponential relationship formula, the second exponential relationship formula, and the third exponential relationship formula.

According to some embodiments, the deriving of the target analysis model includes deriving a first impact value due to a change in the first factor based on a difference between the second exponential relationship formula and the third exponential relationship formula, deriving a second impact value due to a change in the second factor based on a difference between the first exponential relationship formula and the third exponential relationship, and deriving a target exponential relationship formula of the target analysis model by applying the first impact value and the second impact value to the third exponential relationship formula.

According to some embodiments, the first exponential relationship formula, the second exponential relationship formula, and the third exponential relationship formula are formed in the form of $y = A1 * exp(x/t1) + y0$, and the first impact value and the second impact value include a change amount of at least one of coefficients A1, t1, and y0.

According to some embodiments, a non-transitory computer-readable recording medium configured to store commands that allows at least one processor to perform an operation of specifying a plurality of battery analysis factors required to analyze characteristics of a battery, an operation of identifying a plurality of reference analysis models that are established in advance in relation to some of the plurality of battery analysis factors to analyze the characteristics of the battery, and an operation of deriving a target analysis model that analyzes the characteristics of the battery by reflecting the plurality of battery analysis factors based on the plurality of reference analysis models, when executed by the at least one processor.

According to some embodiments, the characteristics of the battery include battery lifetime degradation characteristics, and the plurality of battery analysis factors include a first factor related to a design of a battery cell and a second factor related to a state of charge (SOC) range of a charging and discharging cycle.

According to some embodiments, the battery lifetime degradation characteristics are represented by a change in internal resistance of the battery according to the number of times the charging and discharging cycle, and the plurality of reference analysis models include a plurality of relationship formulas between the number of times the charging and discharging cycle and a change in internal resistance of the battery.

According to some embodiments, the plurality of relationship formulas of the plurality of reference analysis models include a first relationship formula related to a first reference factor that differ from the first factor and the second factor, a second relationship formula related to the first factor and a second reference factor that differs from the second factor, and a third relationship formula related to the first reference factor and the second reference factor.

## Advantageous Effects

According to the embodiments disclosed herein, it is possible to provide the battery analysis device, the battery analysis method, and the recording medium, in which the process of generating the analysis model that requires a long time can be simplified using the already generated similar models.

Technical effects according to the embodiments disclosed herein are not limited to the above-described effects, and other effects that are not described will be able to be clearly understood by those skilled in the art according to the disclosure of the present document.

## Description of Drawings

FIG. 1 illustrates elements of a battery analysis system according to some embodiments.
FIG. 2 illustrates elements of a battery analysis device according to some embodiments.
FIG. 3 illustrates a problem in a method of generating an analysis model based on a linear trend line according to the related art.
FIG. 4 illustrates a plurality of reference analysis models established in advance in relation to some of a plurality of battery analysis elements according to some embodiments.
FIG. 5 illustrates a plurality of relationship formulas representing the plurality of reference analysis models according to some embodiments.
FIG. 6 illustrates a process of deriving a target analysis model using an impact value due to a change in each battery analysis element according to some embodiments.
FIG. 7 illustrates operations of a battery analysis method according to some embodiments.

## Mode for Invention

Hereinafter, embodiments disclosed herein will be described with reference to the accompanying drawings. However, it should be understood that this is not intended to limit the disclosure of the present document to specific embodiments and includes various modifications, equivalents, and/or alternatives of the embodiments described herein.

It should be understood that the embodiments of the present document and the terms used herein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items unless the relevant context clearly dictates otherwise.

In the present document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. Terms such as "first," "second," "first," "second," "A," "B," "(a)," or "(b)" may simply be used to distinguish the corresponding component from another and do not limit the corresponding components in another aspect (e.g., importance or order).

In the present document, when a certain (e.g., a first) component is described as being "coupled," "connected," or "joined" to another (e.g., a second) component with or without the terms "functionally" or "communicatively" or "coupled" or "connected," this means that the certain component may be connected to another component directly (e.g., in a wired or wireless manner) or indirectly (e.g., through a third component).

A method according to various embodiments disclosed herein may be provided by being included in a computer program product. The computer program product may be traded between sellers and buyers as commodities. The computer program product may be distributed in the form of a device-readable storage medium (e.g., a compact disc read only memory (CD-ROM)) or distributed (e.g., downloaded or uploaded) through application stores or directly online between two user devices. In the case of the online distribution, at least some of the computer program products may be at least temporarily stored or temporarily generated in a device-readable storage medium such as a memory of a server of a manufacturer, a server of an application store, or a relay server.

According to the embodiments disclosed herein, each component (e.g., a module or program) of the above-described components may include a single object or a plurality of objects, and some of the plurality of objects may be separately disposed in another component. According to the embodiments disclosed herein, one or more of the above-described corresponding components or operations may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to the embodiments disclosed herein, operations performed by modules, programs, or other components may be executed sequentially, in parallel, repeatedly, or heuristically, or one or more of the operations may be executed in a different order or omitted, or one or more other operations may be added.

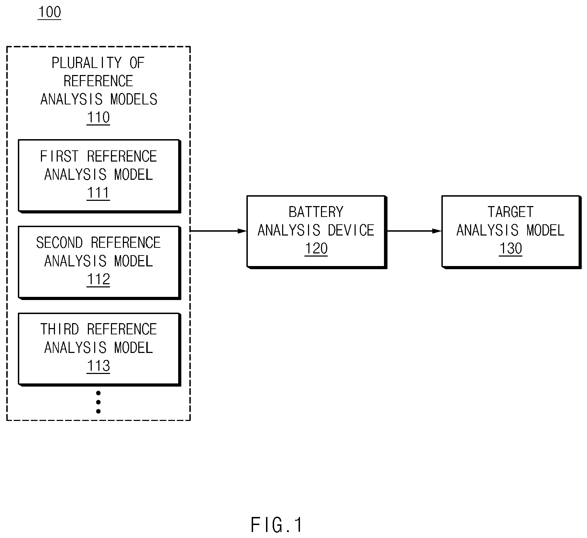

FIG. 1 illustrates elements of a battery analysis system according to some embodiments.

Referring to FIG. 1, in a battery analysis system 100, a battery analysis device 120 may generate a target analysis model 130 based on a plurality of reference analysis models 110.

Characteristics of a battery, such as the lifetime or deterioration of the battery, may be analyzed based on analysis factors such as the type of battery cell design or a state of charge (SOC) range of a charging and discharging cycle. Battery characteristic analysis may be performed by establishing analysis models through experimental data. When the performance or specification requirements of the battery change, changes in the battery analysis factors may also be required.

However, it may be difficult to generate a new model that reflects the changed analysis factors every time. This is because it takes a lot of time and cost to produce a test product that reflects the changed analysis factors and conduct experiments on the test product. In particular, in the case of characteristics that require a long time, such as long-term lifetime evaluation of a battery, it may take several months or more to generate one model.

The battery analysis system 100 may present a method of mathematically deriving a target analysis model without specific prototype production or experiments using conventional similar models when deriving a new model corresponding to a change in only one or some of the battery analysis factors in the previously established analysis model.

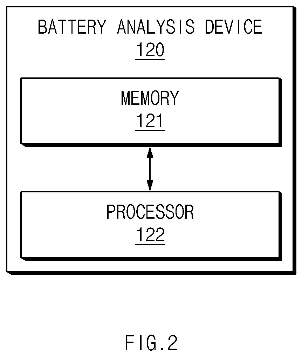

FIG. 2 illustrates elements of a battery analysis device according to some embodiments.

Referring to FIG. 2, the battery analysis device 120 may include a memory 121 and a processor 122. However, the battery analysis device 120 is not limited thereto, and some components may be omitted from the battery analysis device 120, or other general-purpose components may be further included in the battery analysis device 120.

According to an embodiment, the memory 121 and the processor 122 may be electrically connected in the diagnosis device 120 through a device-to-device communication method. The device-to-device communication method may include a bus, a general purpose input and output (GPIO), a serial peripheral interface (SPI), a mobile industry processor interface (MIPI), etc.

The memory 121 may be configured to store various data, commands, software, mobile applications, computer programs, etc. The memory 121 may be operatively coupled with the processor 122. For example, the memory 121 may be implemented as a non-volatile device such as a read only memory (ROM), a programmable ROM (PROM), an erasable PROM (EPROM), an electrically EPROM (EEPROM), a flash memory, a programmable random access memory (PRAM), a magnetoresistive RAM (MRAM), a resistive RAM (RRAM), or a ferroelectric RAM (FRAM), or a volatile device such as a dynamic RAM (DRAM), a static RAM (SRAM), a synchronous dynamic RAM (SDRAM), or a phase change RAM (PRAM), and implemented in the form of a hard disk drive (HDD), a solid-state drive (SSD), a secure digital (SD), a Micro-SD, or a combination thereof.

The processor 122 may have a structure for executing commands that implement the operations of the battery analysis device 120. The processor 122 may process various calculations by executing commands, software, programs, etc. stored in the memory 121. The processor 122 may be implemented as an array of a plurality of logic gates or general-purpose microprocessor for processing various operations and configured as a single processor or a plurality of processors. For example, the processor 122 may be implemented in the form of at least one of a microprocessor, a central processing unit (CPU), a graphic processing unit (GPU), and an application processor (AP).

The processor 122 may be configured to specify a plurality of battery analysis factors required to analyze the characteristics of a battery. For example, the battery analysis factors required to generate a target analysis model may be factors that affect model generation, such as a cell design method and a battery charge/discharge method. Meanwhile, the characteristics of the battery may include characteristics that may be derived through the interpretation of experimental data, such as lifetime characteristics and degradation characteristics.

The processor 122 may be configured to identify a plurality of reference analysis models 110 that are established in advance in relation to some of the plurality of battery analysis factors to analyze the characteristics of the battery. For example, when the plurality of battery analysis factors are identified as a first factor and a second factor, the plurality of reference analysis models 110 previously established for factors similar to the first factor and the second factor may be retrieved. According to an embodiment, the plurality of reference analysis models 110 previously generated may be recorded in a database together with the characteristics of the battery and the plurality of battery analysis factors.

The processor 122 may be configured to derive the target analysis model 130 that analyzes the characteristics of the battery by reflecting the plurality of battery analysis factors based on the plurality of reference analysis models 110. For example, the target analysis model 130 may be derived based on a mathematical proportional relationship. Alternatively, the target analysis model 130 may be derived by a method of quantifying an impact due to a change in each battery analysis factor and applying the quantified impact.

According to an embodiment, the characteristics of the battery may include battery lifetime degradation characteristics, and the plurality of battery analysis factors may include the first factor related to the design of the battery cell and the second factor related to the SOC range of the charging and discharging cycle. The battery lifetime degradation characteristics may be characteristics representing how much the lifetime or performance of the battery is degraded as the battery's usage time increases. The first factor may represent the type of design of the battery cell. For example, the battery cell design may include a structure, manufacturing method, cell configuration, etc. of the battery cell. The structure of the battery cell may include a cylindrical shape, a pouch shape, etc. The manufacturing method of the battery cell may include lamination, stacking, etc. The cell configuration may include the size, number, material, etc. of an electrode, a separator, an electrolyte, etc. The second factor may indicate the SOC range of the charging and discharging cycle. The SOC range of the charging and discharging cycle may include an upper limit value and a lower limit value that are references of full charging and full discharging of the battery. For example, the SOC range of the charging and discharging cycle may include a range of 0 to 100%, 2 to 100%, 4 to 100%, 6 to 100%, 0 to 98%, 2 to 98%, 4 to 98%, 6 to 98%, 0 to 96%, 2 to 96%, 4 to 96%, 6 to 96%, 0 to 94%, 2 to 94%, 4 to 94%, 6 to 94%, or other ranges.

According to an embodiment, the battery lifetime degradation characteristic may be represented by a change in internal resistance of the battery according to the number of times the charging and discharge cycle, and the plurality of reference analysis models 110 may include a plurality of relationship formulas between the number of times the charging and discharging cycle and the change in internal resistance of the battery. It may be interpreted that the lifetime of the battery is degraded as the internal resistance of the battery increases. Alternatively, other indicators that may represent the battery lifetime degradation may be used in addition to the internal resistance of the battery. Each of the reference analysis models 111, 112, and 113 may be represented by a relationship formula. For example, each of the reference analysis models 111, 112, and 113 may be represented by a mathematical formula representing the change in internal resistance of the battery according to the number of times the charging and discharging cycle.

According to an embodiment, the plurality of relationship formulas of the plurality of reference analysis models 110 may include a first relationship formula related to a first reference factor that differs from the first factor and the second factor, a second relationship formula related to the first factor and a second reference factor that differs from the second factor, and a third relationship formula related to the first reference factor and the second reference factor. For example, when the battery analysis factors of the target analysis model 130 are e1 and e2, the first relationship formula of the plurality of reference analysis models 110 may be related to e1' and e2, the second relationship formula may be related to e1 and e2', and the third relationship formula may be related to e1' and e2'. That is, the plurality of relationship formulas of the plurality of reference analysis models 110 differ from the battery analysis factors of the target analysis lysis model 130 but may have similar analysis factors.

According to an embodiment, the first relationship formula, the second relationship formula, and the third relationship formula may include a first exponential relationship formula, the second exponential relationship formula, and the third exponential relationship formula that are derived through numerical analysis fitting for experimental data for the number of times the charging and discharge cycle and the change in internal resistance of the battery. For example, in the case of the first reference analysis model 111, experimental result data for the first reference factor e1' and the second factor e2 may be already present, and the first exponential relationship formula may be derived through the numerical analysis fitting for the experimental result data. The numerical analysis fitting may include various types of curve fitting techniques, and exponential fitting may be applied to the battery lifetime degradation characteristics. The second exponential relationship formula and the third exponential relationship formula may be derived in a similar manner.

According to an embodiment, the processor 122 may be configured to derive a target exponential relationship formula of the target analysis model 130 based on a proportional relationship using a first exponential relationship formula, a second exponential relationship formula, and a third exponential relationship formula. In this case, it may be assumed that a relationship between the first exponential relationship formula e1' and e2 and the third exponential relationship formula e1' and e2' will be mathematically proportional to a relationship between the second exponential relationship formula e1 and e2' and the target exponential relationship formula e1 and e2. According to an embodiment, a weighted proportional relationship of m:n may be used instead of a simple proportion of 1:1. In this case, a weight for a change of e1 and a weight for a change of e2 may be required, which may be inferred through a plurality of reference analysis models recorded in a database.

According to an embodiment, the processor 122 may be configured to derive a first impact value due to a change in the first factor based on a difference between the second exponential relationship formula and the third exponential relationship formula, derive a second impact value due to a change in the second factor based on a difference between the first exponential relationship formula and the third exponential relationship formula, and derive the target exponential relationship formula of the target analysis model by applying the first impact value and the second impact value to the third exponential relationship formula. The first impact value due to the change in the first factor and the second impact value due to the change in the second factor may be a change ratio (multiplication or division), and this case may be similar to a method using a weighted proportional relationship of m:n. According to an embodiment, the first impact value due to the change of the first factor and the second impact value due to the change of the second factor may be a change amount (plus or minus).

According to an embodiment, the first exponential relationship formula, the second exponential relationship formula, and the third exponential relationship formula may be formed in the form of $y = A1*exp(x/t1) + y0$, and the first impact value and the second impact value may include a change amount of at least one of the coefficients A1, t1, and y0. The exponential relationship formula may have the form of a simple exponential relationship formula that does not form an additional complex function, and in this case, three coefficients A1, t1, and y0 may determine the relationship formula. The first impact value and the second impact value may include a change ratio and/or a change amount of the coefficients A1, t1, and y0.

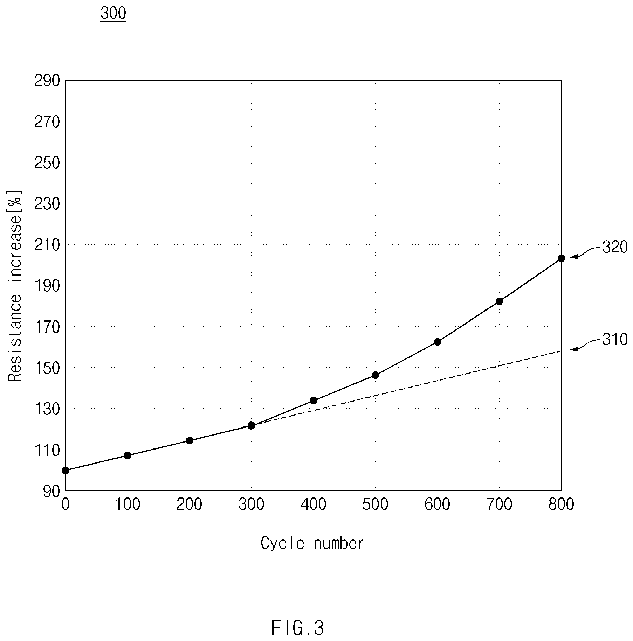

FIG. 3 illustrates a problem in a method of generating an analysis model based on a linear trend line according to the related art.

Referring to FIG. 3, a graph 300 representing a method of generating an analysis model based on a linear trend line according to the related art is illustrated.

In the graph 300, a linear trend line 310 is generated based on data measured up to about 200 cycles, and thus the increase in internal resistance of the battery for subsequent cycles is estimated. However, since actual measured data 320 increases in an exponential trend rather than a linear trend, an error may occur between the linear trend line 310 and the actual measured data 320 in a section exceeding 400 cycles.

The battery analysis device 120 may use the plurality of reference analysis models 110 based on an exponential relationship formula, and the target analysis model 130 generated therefrom may also reflect the exponential trend of the increase in resistance.

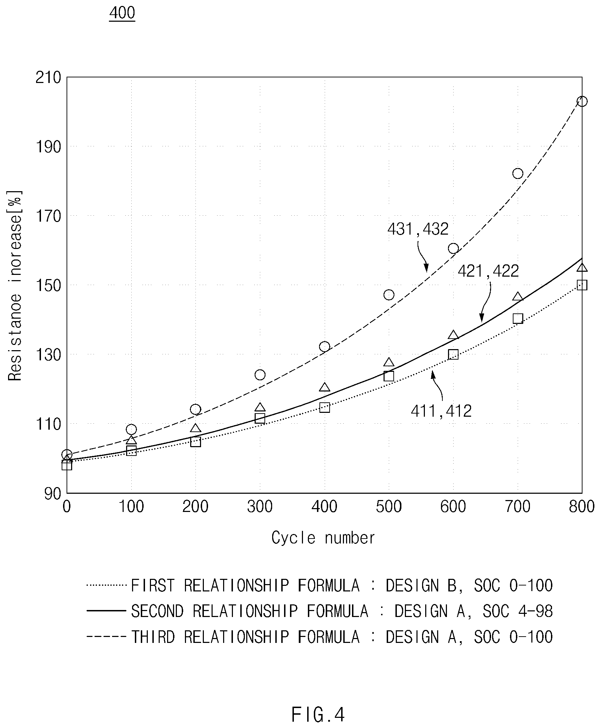

FIG. 4 illustrates a plurality of reference analysis models established in advance in relation to some of a plurality of battery analysis elements according to some embodiments.

Referring to FIG. 4, a graph 400 illustrating the plurality of reference analysis models 110 previously established in relation to some of the plurality of battery analysis factors.

The graph 400 may illustrate a first exponential relationship formula 412, a second exponential relationship formula 422, and a third exponential relationship formula 432. The first exponential relationship formula 412 may be related to a battery cell design B and a SOC range of 0 to 100% of a charging and discharging cycle, the second exponential relationship formula 422 may be related to a battery cell design A and a SOC range of 4 to 98% of a charging and discharging cycle, and the third exponential relationship formula 432 may be related to a battery cell design A and a SOC range of 0 to 100% of a charging and discharging cycle.

In the graph 400, the first exponential relationship formula 412 may be generated through numerical analysis fitting for first experimental data 411 for the battery cell design B and the SOC range of 0 to 100% of the charging and discharge cycle. Specifically, the first exponential relationship formula 412 may be derived through the exponential fitting for the first experimental data 411. Similarly, the second exponential relationship formula 422 may be derived through exponential fitting for second experimental data 421 for the battery cell design A and the SOC range of 4 to 98% of the charging and discharging cycle. Similarly, the third exponential relationship formula 432 may be derived through exponential fitting for third experimental data 431 for the battery cell design A and the SOC range of 0 to 100% of the charging and discharging cycle.

The target exponential relationship formula of the target analysis model 130 may be derived based on the first exponential relationship formula 412, the second exponential relationship formula 422, and the third exponential relationship formula 432. According to an embodiment, the target exponential relationship formula may be derived using a proportional relationship based on the first exponential relationship formula 412, the second exponential relationship formula 422, and the third exponential relationship formula 432, or the first impact value due to the change in first factor (battery cell design) and the second impact value due to the change in second factor (SOC range).

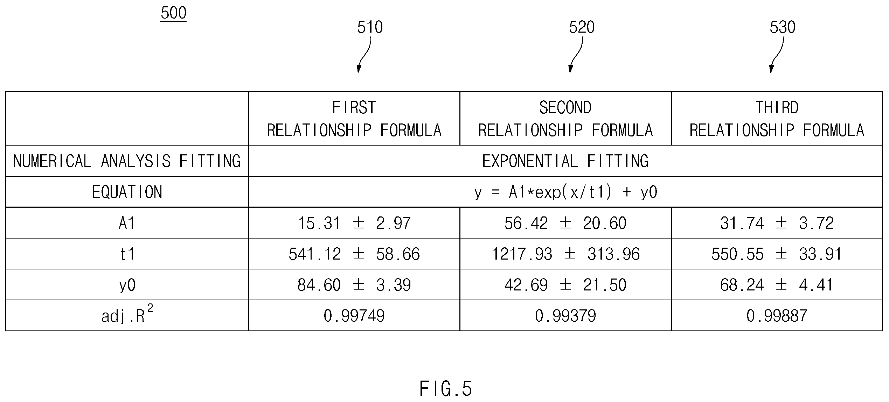

FIG. 5 illustrates a plurality of relationship formulas representing the plurality of reference analysis models according to some embodiments.

Referring to FIG. 5, a table 500 showing a plurality of relationship formulas 510, 520, and 530 representing the plurality of reference analysis models 110 is illustrated.

The first relationship formula 510, the second relationship formula 520, and the third relationship formula 530 may all be generated through exponential fitting. According to an embodiment, in addition to the exponential fitting, other numerical analysis fitting methods such as second-order polynomials may be used. The first relationship formula 510, the second relationship formula 520, and the third relationship formula 530 may all be represented in the form of $y = A1*exp(x/t1) + y0$.

The table 500 may display specific numerical values of the coefficients A1, t1, and y0 that forms the first relationship formula 510, the second relationship formula 520, and the third relationship formula 530. According to the corresponding numerical values, values of the adjusted determination coefficient $adj.R^2$ may be determined. As shown in the table 500, the first relationship formula 510, the second relationship formula 520, and the third relationship formula 530 may all have the adjusted determination coefficient $adj.R^2$ close to 1, and thus can have high fitting suitability.

The target exponential relationship formula of the target analysis model 130 may be derived using the first relationship formula 510, the second relationship formula 520, and the third relationship formula 530. When the first relationship formula 510, the second relationship formula 520, and the third relationship formula 530 are $y_1$, $y_2$, and $y_3$, respectively, and the target exponential relationship formula is $y_t$, the following proportional relationship can be established.

[Equation 1]

$$y_t : y_1 = y_2 : y_3$$

Regarding Equation 1, $y_3$ and $y_2$ have in common that the battery cell design is A and may have different SOC ranges of 0 to 100% and 4 to 98%. Similarly, $y_1$ and $y_t$ have in common that the battery cell design is B and may have different SOC ranges of 0 to 100% and 4 to 98%. Accordingly, under the assumption that the two relationships are similar, Equation 1 can be established. When Equation 1 is summarized, the target exponential relationship formula $y_t$ can be calculated as follows.

[Equation 2]

$$y_t = \frac{y_1 * y_2}{y_3}$$

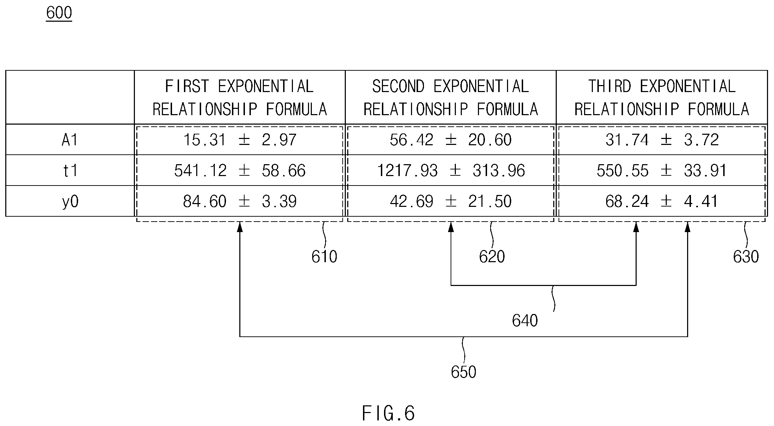

FIG. 6 illustrates a process of deriving a target analysis model using an impact value due to a change in each battery analysis element according to some embodiments.

Referring to FIG. 6, a table 600 showing a process of deriving a target analysis model using an impact value due to a change in each battery analysis element is illustrated.

The table 600 may show first coefficients 610 of the first exponential relationship formula, second coefficients 620 of the second exponential relationship formula, and third coefficients 630 of the third exponential relationship formula. Here, based on a difference between the second coefficients 620 and the third coefficients 630, a first impact value 640 due to the change of the first factor may be derived, and based on a difference between the first coefficients 610 and the third coefficients 630, a second impact value 650 due to the change of the second factor may be derived.

When both the first impact value 640 and the second impact value 650 are applied to the third coefficients 630, coefficients of the target exponential relationship formula may be derived. According to an embodiment, the first impact value 640 and the second impact value 650 may refer to a ratio between the coefficients, and in this case, the coefficients of the target exponential relationship formula may be derived in a manner similar to Equations 1 and 2. Alternatively, the first impact value 640 and the second impact value 650 may refer to a difference ($\pm$) between the coefficients.

According to an embodiment, when the first impact value 640 and the second impact value 650 are applied to the third coefficients 630, a first weight of the first impact value 640 and a second weight of the second impact value 650 may be considered. The first weight and the second weight may be derived from various other models of the database in which the plurality of reference analysis models 110 are stored.

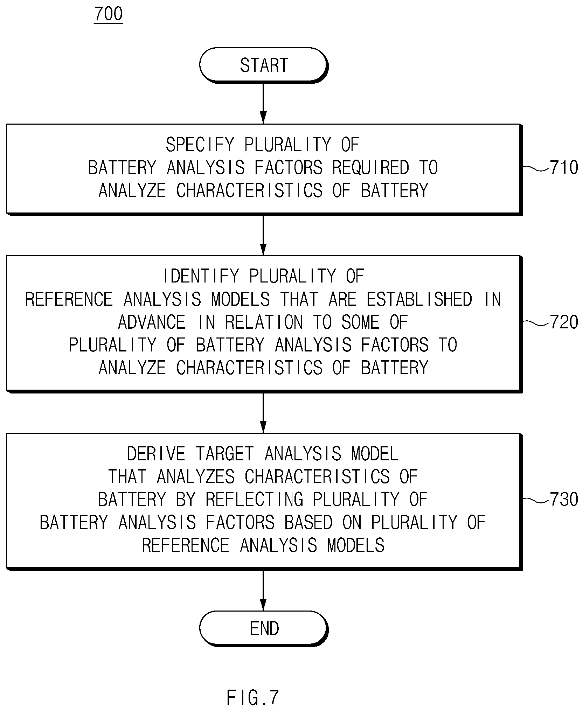

FIG. 7 illustrates operations of a battery analysis method according to some embodiments.

Referring to FIG. 7, a battery analysis method 700 may include operations 710 to 730. However, the embodiments are not limited thereto, and some operations may be omitted or general-purpose operations may be added, and operations 710 to 730 may be executed in a different order from the shown order.

The battery analysis method 700 may be composed of operations that are processed in time series in the battery analysis device 120. Therefore, even when contents are omitted below, the above-described contents for the battery analysis device 120 may be applied to the battery analysis method 700 in the same manner.

Operations 710 to 730 of the battery analysis method 700 may be performed by the memory 121 and the controller 122 of the battery analysis device 120.

In operation 710, the battery analysis device 120 may specify a plurality of battery analysis factors required to analyze the characteristics of a battery.

In operation 720, the battery analysis device 120 may identify a plurality of reference analysis models that are established in advance in relation to some of the plurality of battery analysis factors to analyze the characteristics of the battery.

In operation 730, the battery analysis device 120 may derive a target analysis model that analyzes the characteristics of the battery by reflecting the plurality of battery analysis factors based on the plurality of reference analysis models.

According to an embodiment, the data analysis method 700 may be implemented in the form of a computer program stored in a computer-readable storage medium. That is, the computer program may include commands for implementing the data analysis method 700, and the commands of the program may be stored in the computer-readable storage medium. The computer program may include a mobile application.

According to an embodiment, the computer-readable recording medium may include magnetic media such as a hard disk, a floppy disk, and a magnetic tape, optical media such as a CD-ROM and a DVD, and magneto-optical media such as a floptical disk, and hardware devices specifically configured to store and execute program commands, such as a ROM, a RAM, and a flash memory. The computer program commands may include machine language code generated by a compiler and high-level language code that may be executed by a computer using an interpreter, etc.

The terms such as "comprise," "constitute," or "have" described above mean that the corresponding component may be inherent unless otherwise stated, and thus should be construed as further including another component rather than excluding another component. All terms including technical or scientific terms have the same meaning as commonly understood by those skilled in the art to which the embodiments disclosed herein pertain unless defined otherwise. Commonly used terms, such as terms defined in a dictionary, should be construed as consistent with the contextual meaning of the related art and are not construed in an ideal or excessively formal meaning unless explicitly defined herein.

The above description is merely the exemplary description of the technical spirit disclosed herein, and those skilled in the art to which embodiments disclosed herein pertain will be able to variously modify and change the present document without departing from the essential characteristics of the embodiments disclosed herein. Therefore, the embodiments disclosed herein are not intended to limit the technical spirit disclosed herein, but for illustrative purpose, and the scope of the technical spirit disclosed herein is not limited by these embodiments. The scope of the technical spirit disclosed herein should be construed by the appended claims, and all technical spirits within the equivalent range should be construed as being included in the scope of the present document.

[DESCRIPTION OF DRAWING SYMBOLS]

    100: battery analysis system 110: plurality of reference analysis models
    120: battery analysis device 121: memory
    122: processor 130: target analysis model

**Claims**

1. A battery analysis device comprising:

    a memory; and
    a processor operatively connected to the memory,
    wherein the processor is configured to:

        specify a plurality of battery analysis factors required to analyze characteristics of a battery;
        identify a plurality of reference analysis models that are established in advance in relation to some of the plurality of battery analysis factors to analyze the characteristics of the battery; and
        derive a target analysis model that analyzes the characteristics of the battery by reflecting the plurality of battery analysis factors based on the plurality of reference analysis models.

2. The battery analysis device of claim 1, wherein the characteristics of the battery include battery lifetime degradation characteristics, and
the plurality of battery analysis factors include a first factor related to a design of a battery cell and a second factor related to a state of charge (SOC) range of a charging and discharging cycle.

3. The battery analysis device of claim 2, wherein the battery lifetime degradation characteristics are represented by a change in internal resistance of the battery according to the number of times the charging and discharging cycle, and
the plurality of reference analysis models include a plurality of relationship formulas between the number of times the charging and discharging cycle and a change in internal resistance of the battery.

4. The battery analysis device of claim 3, wherein the plurality of relationship formulas of the plurality of reference analysis models include a first relationship formula related to a first reference factor that differ from the first factor and the second factor, a second relationship formula related to the first factor and a second reference factor that differs from the second factor, and a third relationship formula related to the first reference factor and the second reference factor.

5. The battery analysis device of claim 4, wherein the first relationship formula, the second relationship formula, and the third relationship formula include a first exponential relationship formula, a second exponential relationship formula, and a third exponential relationship formula that are derived through numerical analysis fitting for experimental data for the number of times the charging and discharge cycle and the change in internal resistance of the battery.

6. The battery analysis device of claim 5, wherein the processor is configured to derive a target exponential relationship formula of the target analysis model based on a proportional relationship using a first exponential relationship formula, a second exponential relationship formula, and a third exponential relationship formula.

7. The battery analysis device of claim 5, wherein the processor is configured to:

    derive a first impact value due to a change in the first factor based on a difference between the second exponential relationship formula and the third exponential relationship formula;
    derive a second impact value due to a change in the second factor based on a difference between the first exponential relationship formula and the third exponential relationship; and derive a target exponential relationship formula of the target analysis model by applying the first impact value and the second impact value to the third exponential relationship formula.

8. The battery analysis device of claim 7, wherein the first exponential relationship formula, the second exponential relationship formula, and the third exponential relationship formula are formed in the form of y = A1*exp(x/t1) + y0, and the first impact value and the second impact value include a change amount of at least one of coefficients (A1, t1, and y0).

9. A battery analysis method comprising:

specifying a plurality of battery analysis factors required to analyze characteristics of a battery; identifying a plurality of reference analysis models that are established in advance in relation to some of the plurality of battery analysis factors to analyze the characteristics of the battery; and deriving a target analysis model that analyzes the characteristics of the battery by reflecting the plurality of battery analysis factors based on the plurality of reference analysis models.

10. The battery analysis method of claim 9,

wherein the characteristics of the battery include battery lifetime degradation characteristics, and the plurality of battery analysis factors include a first factor related to a design of a battery cell and a second factor related to a state of charge (SOC) range of a charging and discharging cycle.

11. The battery analysis method of claim 10, wherein the battery lifetime degradation characteristics are represented by a change in internal resistance of the battery according to the number of times the charging and discharging cycle, and the plurality of reference analysis models include a plurality of relationship formulas between the number of times the charging and discharging cycle and a change in internal resistance of the battery.

12. The battery analysis method of claim 11, wherein the plurality of relationship formulas of the plurality of reference analysis models include a first relationship formula related to a first reference factor that differ from the first factor and the second factor, a second relationship formula related to the first factor and a second reference factor that differs from the second factor, and a third relationship formula related to the first reference factor and the second reference factor.

13. The battery analysis method of claim 12, wherein the first relationship formula, the second relationship formula, and the third relationship formula include a first exponential relationship formula, a second exponential relationship formula, and a third exponential relationship formula that are derived through numerical analysis fitting for experimental data for the number of times the charging and discharge cycle and the change in internal resistance of the battery.

14. The battery analysis method of claim 13, wherein the deriving of the target analysis model includes deriving a target exponential relationship formula of the target analysis model based on a proportional relationship using the first exponential relationship formula, the second exponential relationship formula, and the third exponential relationship formula.

15. The battery analysis method of claim 13, wherein the deriving of the target analysis model includes:

deriving a first impact value due to a change in the first factor based on a difference between the second exponential relationship formula and the third exponential relationship formula; deriving a second impact value due to a change in the second factor based on a difference between the first exponential relationship formula and the third exponential relationship; and deriving a target exponential relationship formula of the target analysis model by applying the first impact value and the second impact value to the third exponential relationship formula.

16. The battery analysis method of claim 15, wherein the first exponential relationship formula, the second exponential relationship formula, and the third exponential relationship formula are formed in the form of y = A1*exp(x/t1) + y0, and the first impact value and the second impact value include a change amount of at least one of coefficients (A1, t1, and y0).

17. A non-transitory computer-readable recording medium configured to store commands that allows at least one processor to perform:

an operation of specifying a plurality of battery analysis factors required to analyze characteristics of a battery; an operation of identifying a plurality of reference analysis models that are established in advance in relation to some of the plurality of battery analysis factors to analyze the characteristics of the battery; and
an operation of deriving a target analysis model that analyzes the characteristics of the battery by reflecting the plurality of battery analysis factors based on the plurality of reference analysis models, when executed by the at least one processor.

18. The non-transitory computer-readable recording medium of claim 17, wherein the characteristics of the battery include battery lifetime degradation characteristics, and
the plurality of battery analysis factors include a first factor related to a design of a battery cell and a second factor related to a state of charge (SOC) range of a charging and discharging cycle.

19. The non-transitory computer-readable recording medium of claim 18, wherein the battery lifetime degradation characteristics are represented by a change in internal resistance of the battery according to the number of times the charging and discharging cycle, and
the plurality of reference analysis models include a plurality of relationship formulas between the number of times the charging and discharging cycle and a change in internal resistance of the battery.

20. The non-transitory computer-readable recording medium of claim 19, wherein the plurality of relationship formulas of the plurality of reference analysis models include a first relationship formula related to a first reference factor that differ from the first factor and the second factor, a second relationship formula related to the first factor and a second reference factor that differs from the second factor, and a third relationship formula related to the first reference factor and the second reference factor.

100

```
┌ ─ ─ ─ ─ ─ ─ ─ ─ ─ ─ ─ ┐
│   PLURALITY OF        │
│    REFERENCE          │
│  ANALYSIS MODELS      │
│      110              │
│                       │
│  ┌─────────────────┐  │
│  │ FIRST REFERENCE │  │
│  │ ANALYSIS MODEL  │  │
│  │      111        │  │
│  └─────────────────┘  │
│                       │
│  ┌─────────────────┐  │
│  │ SECOND REFERENCE│  │
│  │ ANALYSIS MODEL  │  │
│  │      112        │  │
│  └─────────────────┘  │
│                       │
│  ┌─────────────────┐  │
│  │ THIRD REFERENCE │  │
│  │ ANALYSIS MODEL  │  │
│  │      113        │  │
│  └─────────────────┘  │
│          ⋮            │
└ ─ ─ ─ ─ ─ ─ ─ ─ ─ ─ ─ ┘
```

BATTERY ANALYSIS DEVICE 120

TARGET ANALYSIS MODEL 130

FIG.1

FIG.2

300

FIG.3

400

FIG.4

EP 4 764 524 A1

500

510                           520                           530

| | FIRST RELATIONSHIP FORMULA | SECOND RELATIONSHIP FORMULA | THIRD RELATIONSHIP FORMULA |
|---|---|---|---|
| NUMERICAL ANALYSIS FITTING | EXPONENTIAL FITTING | | |
| EQUATION | $y = A1*exp(x/t1) + y0$ | | |
| A1 | $15.31 \pm 2.97$ | $56.42 \pm 20.60$ | $31.74 \pm 3.72$ |
| t1 | $541.12 \pm 58.66$ | $1217.93 \pm 313.96$ | $550.55 \pm 33.91$ |
| y0 | $84.60 \pm 3.39$ | $42.69 \pm 21.50$ | $68.24 \pm 4.41$ |
| $adj.R^2$ | 0.99749 | 0.99379 | 0.99887 |

FIG.5

600

| | FIRST EXPONENTIAL RELATIONSHIP FORMULA | SECOND EXPONENTIAL RELATIONSHIP FORMULA | THIRD EXPONENTIAL RELATIONSHIP FORMULA |
|---|---|---|---|
| A1 | 15.31 ± 2.97 | 56.42 ± 20.60 | 31.74 ± 3.72 |
| t1 | 541.12 ± 58.66 | 1217.93 ± 313.96 | 550.55 ± 33.91 |
| y0 | 84.60 ± 3.39 | 42.69 ± 21.50 | 68.24 ± 4.41 |

610

620

630

640

650

FIG.6

<u>700</u>

```
                          ┌────────────┐
                          │   START    │
                          └─────┬──────┘
                                │
                                ▼
    ┌───────────────────────────────────────────────────┐
    │              SPECIFY PLURALITY OF                  │
    │   BATTERY ANALYSIS FACTORS REQUIRED TO             │───710
    │   ANALYZE CHARACTERISTICS OF BATTERY               │
    └───────────────────────┬───────────────────────────┘
                                │
                                ▼
    ┌───────────────────────────────────────────────────┐
    │             IDENTIFY PLURALITY OF                  │
    │  REFERENCE ANALYSIS MODELS THAT ARE ESTABLISHED IN │
    │       ADVANCE IN RELATION TO SOME OF               │───720
    │    PLURALITY OF BATTERY ANALYSIS FACTORS TO        │
    │        ANALYZE CHARACTERISTICS OF BATTERY          │
    └───────────────────────┬───────────────────────────┘
                                │
                                ▼
    ┌───────────────────────────────────────────────────┐
    │           DERIVE TARGET ANALYSIS MODEL             │
    │        THAT ANALYZES CHARACTERISTICS OF            │
    │      BATTERY BY REFLECTING PLURALITY OF            │───730
    │   BATTERY ANALYSIS FACTORS BASED ON PLURALITY OF   │
    │            REFERENCE ANALYSIS MODELS               │
    └───────────────────────┬───────────────────────────┘
                                │
                                ▼
                          ┌────────────┐
                          │    END     │
                          └────────────┘
```

FIG.7

## INTERNATIONAL SEARCH REPORT

| | International application No. |
|---|---|
| | **PCT/KR2024/096480** |

### A. CLASSIFICATION OF SUBJECT MATTER

**G01R 31/367**(2019.01)i; **G01R 31/396**(2019.01)i; **G01R 31/392**(2019.01)i; **G01R 31/382**(2019.01)i; **G01R 31/36**(2006.01)i

According to International Patent Classification (IPC) or to both national classification and IPC

### B. FIELDS SEARCHED

Minimum documentation searched (classification system followed by classification symbols)

G01R 31/367(2019.01); B60L 50/50(2019.01); G01R 31/36(2006.01); G06N 3/04(2006.01); G06N 3/08(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 수명(lifetime), 모델(model), 충방전 사이클(charging and discharging cycle), 퇴화(degeneracy)

### C. DOCUMENTS CONSIDERED TO BE RELEVANT

| Category* | Citation of document, with indication, where appropriate, of the relevant passages | Relevant to claim No. |
|---|---|---|
| A | KR 10-2023-0054190 A (LG ENERGY SOLUTION, LTD.) 24 April 2023 (2023-04-24)<br>See paragraphs [0026] and [0040]-[0061], claims 1 and 3 and figures 3 and 6. | 1-20 |
| A | KR 10-2018-0138329 A (HYUNDAI MOTOR COMPANY et al.) 31 December 2018 (2018-12-31)<br>See paragraphs [0037]-[0042], claim 1 and figure 2. | 1-20 |
| A | KR 10-2020-0087494 A (SAMSUNG ELECTRONICS CO., LTD. et al.) 21 July 2020 (2020-07-21)<br>See paragraphs [0036]-[0059], claims 2-8 and figures 2-4. | 1-20 |
| A | KR 10-2023-0003848 A (HYUNDAI MOTOR COMPANY et al.) 06 January 2023 (2023-01-06)<br>See paragraphs [0063]-[0073] and figure 2. | 1-20 |
| A | KR 10-2386980 B1 (SAMSUNG ELECTRONICS CO., LTD. et al.) 15 April 2022 (2022-04-15)<br>See paragraphs [0041]-[0045], claim 1 and figure 2. | 1-20 |

☐ Further documents are listed in the continuation of Box C.      ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **18 February 2025** | **18 February 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

| INTERNATIONAL SEARCH REPORT<br>Information on patent family members | | | International application No.<br>**PCT/KR2024/096480** | |

| Patent document<br>cited in search report | | | Publication date<br>(day/month/year) | Patent family member(s) | | | Publication date<br>(day/month/year) |
|---|---|---|---|---|---|---|---|
| KR | 10-2023-0054190 | A | 24 April 2023 | None | | | |
| KR | 10-2018-0138329 | A | 31 December 2018 | DE | 102017128901 | A1 | 27 December 2018 |
| | | | | KR | 10-2417895 | B1 | 07 July 2022 |
| | | | | US | 2018-0375130 | A1 | 27 December 2018 |
| KR | 10-2020-0087494 | A | 21 July 2020 | US | 11422191 | B2 | 23 August 2022 |
| | | | | US | 11680987 | B2 | 20 June 2023 |
| | | | | US | 2020-0225288 | A1 | 16 July 2020 |
| | | | | US | 2022-0349942 | A1 | 03 November 2022 |
| KR | 10-2023-0003848 | A | 06 January 2023 | CN | 115542162 | A | 30 December 2022 |
| | | | | US | 2023-0003801 | A1 | 05 January 2023 |
| KR | 10-2386980 | B1 | 15 April 2022 | KR | 10-2016-0090226 | A | 29 July 2016 |
| | | | | US | 10401433 | B2 | 03 September 2019 |
| | | | | US | 2016-0209472 | A1 | 21 July 2016 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230160241